# EUROPEAN PATENT SPECIFICATION

(11) **EP 3 062 333 B1**
(45) Date of publication and mention of the grant of the patent: **12.06.2019**
(21) Application number: 14878983.7
(22) Date of filing: 26.12.2014
(51) Int. Cl.: H01L 21/67, H01L 21/687, H01L 21/68

(54) **NORMAL TEMPERATURE BONDING DEVICE**
NORMALTEMPERATUR-BINDUNGSVORRICHTUNG
DISPOSITIF DE LIAISON À TEMPÉRATURE NORMALE

(30) Priority: 17.01.2014 JP 2014006869
(43) Date of publication of application: 31.08.2016
(73) Proprietor: Mitsubishi Heavy Industries Machine Tool Co., Ltd., Ritto-shi Shiga 520-3080 (JP)
(72) Inventor: KINOUCHI, Masato, Tokyo 108-8215 (JP); GOTO, Takayuki, Tokyo 108-8215 (JP); TSUNO, Takeshi, Tokyo 108-8215 (JP); IDE, Kensuke, Tokyo 108-8215 (JP); SUZUKI, Takenori, Tokyo 108-8215 (JP)
(74) Representative: Henkel, Breuer & Partner
(86) International application number: PCT/JP2014/084495
(87) International publication number: WO 2015/107855

(56) References cited:
- EP-A1- 2 249 377
- EP-A2- 1 584 447
- JP-A- H05 160 340
- JP-A- 2009 208 084
- JP-A- 2011 119 293
- US-A1- 2003 179 353

## Description

### Technical Field

The present invention relates to a room-temperature bonding apparatus.

### Background Art

As a technique to bond two wafers (substrates), the room-temperature bonding is known. In the room-temperature bonding, the surfaces of two wafers to be bonded are activated in a vacuum ambience, and then the activated wafer surfaces are brought into contact with each other, so as to bond the two wafers. As a technique to activate the wafer surface, for example, a method of using an ion beam and a method of using a neutral atom beam are known.

One of the basic techniques of the room-temperature bonding is the positioning of wafers to be bonded. In recent years, the downsizing and precious fabrication of a device have progressed and as a result of it, it is important to precisely position the wafers to be bonded. As a method of positioning the wafers preciously, the technique to position the wafers by using a piezo-electric device is known (for example, reference to JP 4,822,577 B and JP 4,669,766 B).

The use of the piezo-electric device has a problem that a sufficiently large stroke (movable range) cannot be provided although being preferable for the precise positioning. As a technique to deal with such a problem, a technique that uses a combination of a coarse movement stage and a fine movement stage is known (for example, JP 2005-288637 A and JP H05-160340 A).

Another important matter on the positioning of wafers in the room-temperature bonding is a withstand load property of a stage mechanism used for the positioning. In the room-temperature bonding, it is necessary to apply a large bonding load (for example, maximum load of 10 tons) on the wafers to be bonded. Accordingly, the stage mechanism to be used for the positioning of the wafers has to be designed to withstand the large bonding load. JP 3,970,304 B discloses a technique to improve a withstand load property of the stage mechanism. In the stage mechanism disclosed in this Patent, the carriage that holds a wafer is coupled to the positioning stage by elastic guides. Moreover, a carriage support base is disposed in addition to the positioning stage. When any load is not applied to the carriage, the carriage is supported so as not to contact the carriage support base. When a load is applied to the carriage, the elastic guides are transformed elastically to bring the carriage into contact with the carriage support base. Thus, the load is distributed over the carriage support base, and the pressure applied to the positioning stage is reduced.

However, the above-mentioned prior art techniques do not provide a new stage mechanism that satisfies requests of precise positioning of wafers and improvement of the withstand load property of the stage mechanism, while having a sufficiently large stroke.

It should be noted that as a technique related to the present invention, JP 4,209,457 B discloses a room-temperature bonding apparatus in which an angle adjusting mechanism is disposed on an upper stage to adjust the orientation of a sample table.

EP 2249377 A1, on which the preamble portion of claim 1 is based, describes an alignment device using infrared illumination and inter alia a transparent portion formed in a carriage support table and a lower sample stage.

EP 158447 A2 discloses a manufacturing system for a microstructure which includes a rough motion stage and a fine motion stage. The moving position of the fine motion stage is controlled by measuring its position by means of two laser length measuring machines that are provided along the XY direction beside a vacuum container in order to measure a current position of a mirror attached to the fine motion stage by use of interferometry of a laser and using the determination of a position difference detected in this way to control the position of the fine motion stage.

US 2003/179353 A1 discloses an alignment device comprising a movable table for positioning a wafer. A target positioning accuracy can be confirmed by reading recognition marks provided on the wafer or a chuck with an infrared camera, a visual-ray camera or a laser arranged below the table.

### Summary of the Invention

Therefore, a subject matter of the present invention is to provide a room-temperature bonding apparatus having a stage mechanism that satisfies requests of precise alignment of wafers and a withstand load property while having a large stroke.

The present invention provides a room-temperature bonding apparatus with the features of claim 1 including a bonding chamber, an upper-side stage mechanism configured to support an upper-side wafer to be movable in an upper and lower direction in the bonding chamber, and a lower-side stage mechanism configured to support a lower-side wafer to be movable in a horizontal plane in the bonding chamber. The lower-side stage mechanism includes a carriage having a lower-side wafer holding section for holding the lower-side wafer, an elastic guide coupled to the carriage to support the carriage, a positioning stage configured to coarsely move the lower-side wafer holding section, a fine movement mechanism configured to finely move the lower-side wafer holding section, and a carriage support base. The elastic guide supports the carriage such that the carriage does not contact the carriage support base when any load is not applied to the carriage from the upper-side stage mechanism, and elastically deforms such that the carriage contacts the carriage support base when the upper-side wafer contacts the lower-side wafer by the upper-side stage mechanism and a load is applied to the carriage in the upper and lower direction.

In the invention, the positioning stage drives the elastic guide to coarsely move the lower-side wafer holding section and the fine movement mechanism is incorporated in the carriage.

In the invention, the carriage contains a carriage plate to which the elastic guide is joined, the lower-side wafer holding section is arranged above the carriage plate, and the fine movement mechanism may include a frame disposed on the carriage plate and a driving mechanism configured to drive the lower-side wafer holding section connected to the frame. In this case, when the upper-side wafer is brought into contact with the lower-side wafer by the upper-side stage mechanism and the load is applied to the carriage in the upper and lower direction, the elastic guide elastically deforms such that the carriage plate contacts the carriage support base.

At this time, a support mechanism may be provided for the frame to support the lower-side wafer holding section to be movable in the upper and lower direction. In an embodiment, the support mechanism supports the lower-side wafer holding section such that the lower-side wafer holding section does not contact the carriage plate when any load is not applied to the lower-side wafer holding section from the upper-side stage mechanism, and elastically deforms such that the lower-side wafer holding section contacts the carriage plate when the upper-side wafer contacts the lower-side wafer by the upper-side stage mechanism and the load is applied to the lower-side wafer holding section in the upper and lower direction.

In the above-mentioned room-temperature bonding apparatus, the upper-side stage mechanism may include an upper-side wafer holding section for holding the upper-side wafer; and an angle adjustment mechanism which adjusts the orientation of the upper-side wafer holding section. In an embodiment, the upper-side stage mechanism includes an elevation rod moved in the upper and lower direction. In this case, preferably, the angle adjustment mechanism includes a spherical flange fixed to the upper-side wafer holding section, a spherical seat fixed to the elevation rod, and a fixation flange fixed to the spherical seat, and coupling the spherical flange to the spherical seat by supporting the spherical flange therein.

According to the above embodiments, the room-temperature bonding apparatus can be provided to have the stage mechanism that satisfies requests of the precise alignment of wafers and the large withstand load property, while having a large stroke.

### Brief Description of the Drawings

[FIG. 1]

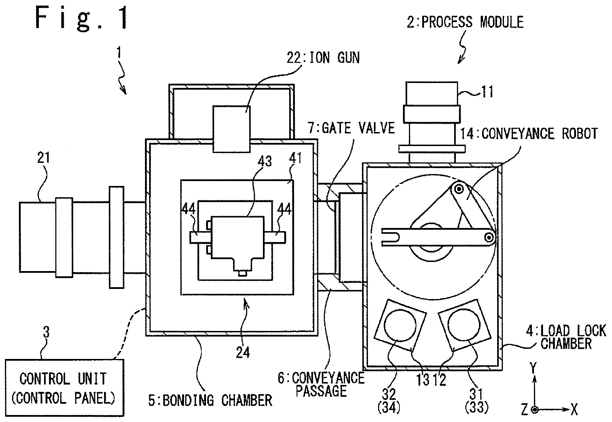

   FIG. 1 is a horizontal sectional view schematically showing the configuration of a room-temperature bonding apparatus according to a first example serving to explain aspects of the invention.
[FIG. 2]

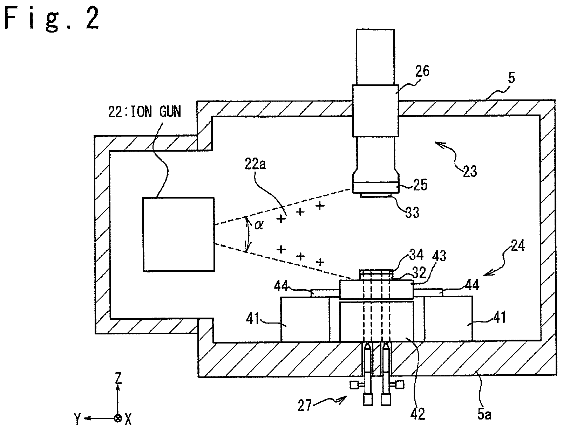

   FIG. 2 is a vertical sectional view schematically showing the configuration of a bonding chamber in the first example.
[FIG. 3]

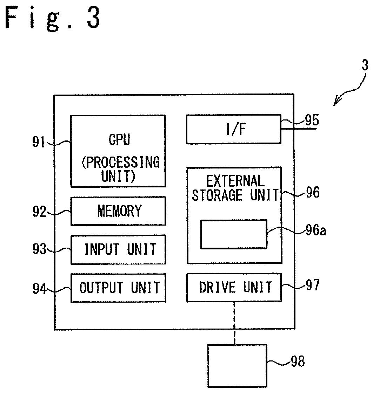

   FIG. 3 is a block diagram schematically showing the configuration of a control unit in the first example.
[FIG. 4A]

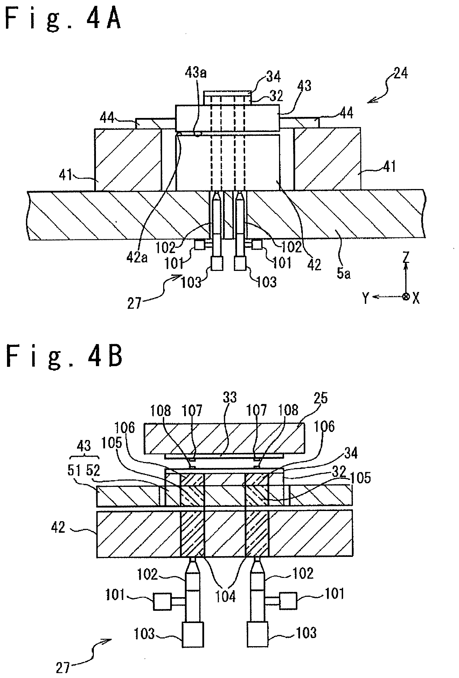

   FIG. 4A is a sectional view schematically showing the configuration of a lower-side stage mechanism in the first example.
[FIG. 4B]
   FIG. 4B is a sectional view showing the configuration of an alignment mechanism that is incorporated into the lower-side stage mechanism.
[FIG. 5A]

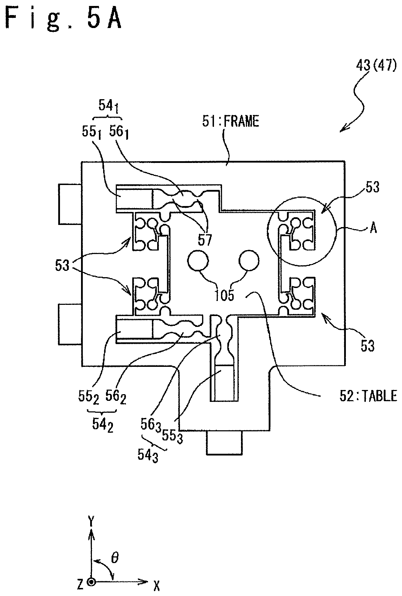

   FIG. 5A is a plan view showing the configuration of a carriage in the first example.
[FIG. 5B]

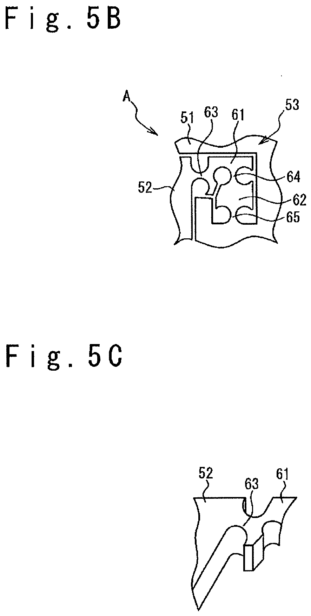

   FIG. 5B is a plan view showing the configuration of a hinge section of the carriage.
[FIG. 5C]
   FIG. 5C is a perspective view showing the configuration of a hinge section of the carriage.
[FIG. 6]

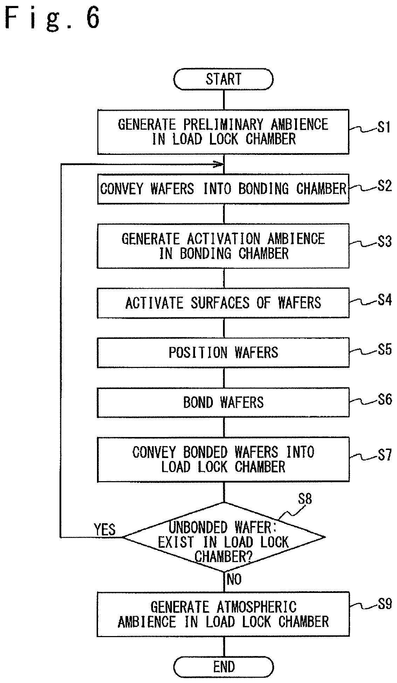

   FIG. 6 is a flow chart showing a room-temperature bonding method in the first example.
[FIG. 7]
   FIG, 7 is a sectional view schematically showing the configuration of the room-temperature bonding apparatus in an embodiment of the invention.
[FIG. 8]

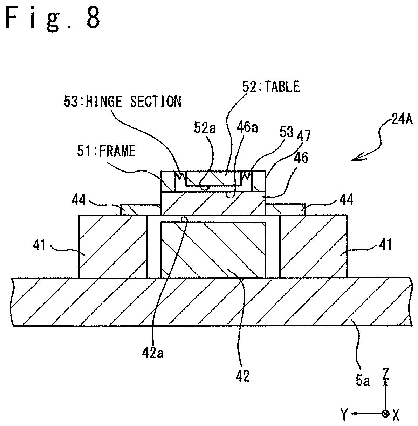

   FIG. 8 is a sectional view schematically showing the configuration of the lower-side stage mechanism in a modification example of the room-temperature bonding apparatus of the embodiment.
[FIG. 9]

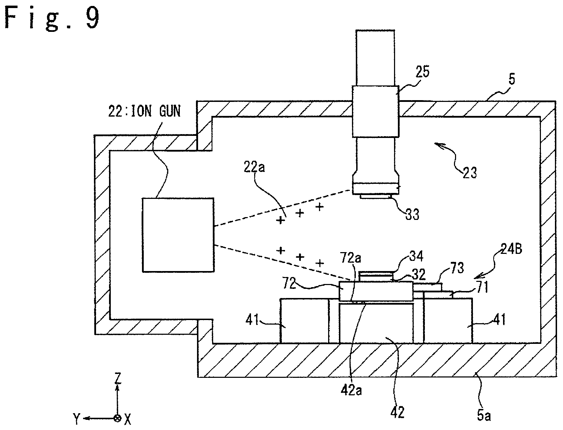

   FIG. 9 is a sectional view schematically showing the configuration of the room-temperature bonding apparatus in a second example serving to explain aspects of the invention.
[FIG. 10]

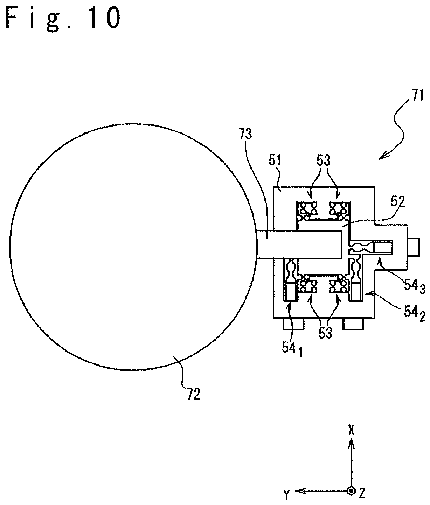

   FIG. 10 is a plan view showing the configuration of a fine movement stage and the carriage in the second example.
[FIG. 11]

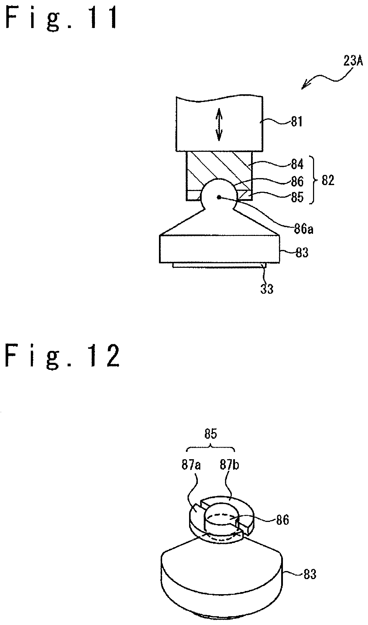

   FIG. 11 is a side view schematically showing the configuration of the upper-side stage mechanism in one embodiment.
[FIG. 12]
   FIG. 12 is a perspective view showing the configuration of a fixation flange of the upper-side stage mechanism of FIG. 11.

### Description of the Embodiments

Hereinafter, embodiments of the present invention and examples serving to explain features of the invention will be described with reference to the attached drawings. Note that an identical or similar component is referred to using an identical or similar reference numeral in the following description.

### [First Example]

FIG. 1 is a horizontal sectional view schematically showing the configuration of a room-temperature bonding apparatus 1 according to a first example. In the following description, XYZ rectangular coordinate system is used according to necessity. Note that a Z axis is defined as an upper and lower direction (a vertical direction), an X axis is defined as a specific direction on a plane parallel to a horizontal plane, and a Y axis is defined as a direction orthogonal to the X axis and the Z axis.

The room-temperature bonding apparatus 1 includes a process module 2 that carries out the room-temperature bonding, and a control unit (a control panel) 3 that controls the process module 2.

The process module 2 includes a load lock chamber 4 and a bonding chamber 5. The load lock chamber 4 is a chamber that is used for conveyance of a wafer between an external environment and the bonding chamber 5. The bonding chamber 5 is a chamber where the bonding of wafers is actually carried out.

The process module 2 includes a conveyance passage 6 and a gate valve 7. The conveyance passage 6 is interposed between the load lock chamber 4 and the bonding chamber 5 to couple the inner space of the bonding chamber 5 and the inner space of the load lock chamber 4. The gate valve 7 closes or opens the conveyance passage 6 under a control of the control unit 3. That is, the gate valve 7 has a function to connect or disconnect the inner space of the load lock chamber 4 to or from the inner space of the bonding chamber 5.

The load lock chamber 4 includes a lid (not shown) and a vacuum exhaust unit 11. The lid closes or opens an opening (not shown) which connects the external environment and the inner space of the load lock chamber 4, through an operation by a user. The vacuum exhaust unit 11 exhausts gas from the inner space of the load lock chamber 4 under the control of the control unit 3.

Moreover, the load lock chamber 4 houses cartridge stands 12 and 13 and a conveyance robot 14. Cartridges 31 and 32 to hold the wafers to be bonded are put on the cartridge stands 12 and 13, respectively. The cartridge 31 holds the wafer to be located on an upper side (hereinafter, to be referred to as an upper-side wafer 33) in case of the bonding of the wafers. The cartridge 32 holds the wafer to be located on a lower side (hereinafter, to be referred to as a lower-side wafer 34). When the gate valve 7 is opened, the conveyance robot 14 conveys the cartridges 31 and 32 arranged on the cartridge stands 12 and 13 through the conveyance passage 6 into the inner space of the bonding chamber 5, or conveys the cartridges 31 and 32 from the inner space of the bonding chamber 5 to the cartridge stands 12 and 13.

The bonding chamber 5 has a vacuum exhaust unit 21. The vacuum exhaust unit 21 exhausts gas from the inner space of the bonding chamber 5 under the control of the control unit 3.

FIG. 2 is a sectional view schematically showing the configuration of the bonding chamber 5. As shown in FIG. 2, the bonding chamber 5 includes an ion gun 22, an upper-side stage mechanism 23 and a lower-side stage mechanism 24. The ion gun 22 irradiates an ion beam 22a that is used for activation of the surfaces of the wafers. Through the irradiation of the ion beam 22a, the activation of the surfaces of the upper-side wafer 33 supported by the upper-side stage mechanism 23 and the lower-side wafer 34 supported by the lower-side stage mechanism 24 is carried out. Note that in the present example, one ion gun 22 is used for the activation of the surfaces of the wafers but a plurality of ion guns 22 may be used. Also, instead of the ion gun 22, another activation means (e.g. a neutral atom beam source) may be used for the activation of the wafers.

The upper-side stage mechanism 23 is a mechanism to carry out the positioning of the upper-side wafer 33, and includes an electrostatic chuck 25 and a pressure welding mechanism 26. The electrostatic chuck 25 functions as an upper-side wafer holding section that holds the upper-side wafer 33. In detail, the electrostatic chuck 25 includes a dielectric layer, and has a flat surface that is perpendicular to an upper and lower direction (the Z axial direction) at the lower end of the dielectric layer. The electrostatic chuck 25 further includes an internal electrode that is arranged inside the dielectric layer. The electrostatic chuck 25 applies a predetermined voltage to the internal electrode under the control of the control unit 3, and holds the upper-side wafer 33 that is arranged in the neighborhood of the flat surface of the dielectric layer by an electrostatic force.

The pressure welding mechanism 26 lifts up or down the electrostatic chuck 25 in the upper and lower direction (the Z axial direction) under the control of the control unit 3. In the first example, the pressure welding mechanism 26 positions the electrostatic chuck 25 at a desired position under the control of the control unit 3. Moreover, the pressure welding mechanism 26 measures the position of the electrostatic chuck 25 (that is, a position of the upper-side wafer 33) and outputs data indicative of the measured position under the control of the control unit 3. Moreover, the pressure welding mechanism 26 measures a load applied to the upper-side wafer 33 that is held by the electrostatic chuck 25, and outputs data indicative of the measured load, under the control of the control unit 3.

The lower-side stage mechanism 24 is a mechanism to carry out the positioning of the lower-side wafer 34 and holds the cartridge 32 put thereon. Thus, the lower-side stage mechanism 24 holds the lower-side wafer 34 put on the cartridge 32. The details of the lower-side stage mechanism 24 will be described later.

Moreover, the bonding chamber 5 includes an alignment mechanism 27. The alignment mechanism 27 picks up an image of an alignment mark formed on the surface of the upper-side wafer 33 held by the upper-side stage mechanism 23 and an image of the alignment mark of the lower-side wafer 34 put on the lower-side stage mechanism 24. The picked-up images are sent to the control unit 3 that carries out image processing. Thus, the control unit 3 detects a difference in the position on the XY plane between the upper-side wafer 33 and the lower-side wafer 34 and a difference in the orientation between them in the XY plane. The details of alignment mechanism 27 will be described later. The position and orientation differences between the upper-side wafer 33 and the lower-side wafer 34 obtained by using the alignment mechanism 27 are used for control of the lower-side stage mechanism 24.

FIG. 3 is a block diagram schematically showing the configuration of the control unit 3 in the present example. The control unit 3 is an information processing unit that is exemplified by a computer, and includes a CPU (Central Processing Unit) 91, a memory 92, an input unit 93, an output unit 94, an interface (I/F) 95, an external storage unit 96 and a drive unit 97. The CPU 91, the memory 92, the input unit 93, the output unit 94, the interface 95, the external storage unit 96 and the drive unit 97 are connected to each other to be communicable.

The CPU 91 develops a computer program 96a installed in the external storage unit 96, on the memory 92. Moreover, the CPU 91 executes the developed computer program 96a to attain information processing of the computer program 96a while controlling hardware resources such as the input unit 93, the output unit 94, and the external storage unit 96 according to need.

The external storage unit 96 stores the computer program 96a and stores data used or generated by the CPU 91. A recording medium 98 in which the computer program 96a is recorded may be used for the installation of the computer program 96a into the external storage unit 96. The computer program 96a is read from the recording medium 98 by the drive unit 97 and is written in the external storage unit 96.

The input unit 93 outputs data generated through an operation by a user to the CPU 91 and the external storage unit 96. The output unit 94 outputs data generated by the CPU 91 and data stored in the external storage unit 96 to the user to be recognizable.

The interface 95 is used for the communication between each device of the process module 2 and the control unit 3. Specifically, the interface 95 transmits control signals to control the gate valve 7, the conveyance robot 14, the vacuum exhaust units 11 and 21, the ion gun 22, the upper-side stage mechanism 23 (that is, the electrostatic chuck 25 and the pressure welding mechanism 26) and the lower-side stage mechanism 24, and receives signals transmitted from these units.

The computer program 96a installed in the control unit 3 contains a program code group to make the control unit 3 realize desired functions. First, the program code group provides the function to control the process module 2 for the purpose of the conveyance, setting and taking-out of the wafers 33 and 34. In this function, the control of the vacuum exhaust unit 11 of the load lock chamber 4, the control of the opening and closing of the gate valve 7, the control of the conveyance of the cartridges 31 and 32 by the conveyance robot 14, the control of the electrostatic chuck 25 and the control of the pressure welding mechanism 26 are mainly carried out. Second, the program code group provides the function to control the process module 2 for the purpose of activation of the wafers 33 and 34. In this function, the control of the vacuum exhaust unit 21 of the bonding chamber 5, the control of the pressure welding mechanism 26, and the control of the ion gun 22 are mainly carried out. Third, the program code group provides the function to control the process module 2 for purpose of the bonding of wafers 33 and 34. In this function, the control of the electrostatic chuck 25, the control of the pressure welding mechanism 26 and the control of the lower-side stage mechanism 24 are mainly carried out.

One feature of the room-temperature bonding apparatus 1 of the present example is in the configuration of the lower-side stage mechanism 24. In the present example, the lower-side stage mechanism 24 is configured to satisfy both of the precise positioning of the wafers and a large withstand load property while providing a sufficiently large stroke. Hereinafter, the configuration of the lower-side stage mechanism 24 of the present example will be described in detail.

FIG. 4A is a diagram schematically showing the configuration of the lower-side stage mechanism 24. The lower-side stage mechanism 24 includes a positioning stage 41, a carriage support table 42, a carriage 43 and elastic guides 44. The positioning stage 41 and the carriage support table 42 are supported by a bottom plate 5a of the bonding chamber 5. To be described later, the positioning stage 41 functions as a coarse movement stage that coarsely moves the lower-side wafer 34 in a large stroke. The carriage support table 42 has a smooth support surface 42a at the upper end. The support surface 42a is perpendicular to the upper and lower direction (the Z axial direction).

The carriage 43 holds the cartridge 32 put thereon (and the lower-side wafer 34 put on the cartridge 32). To be described later in detail, in the present example, a function of a fine movement stage to finely move the lower-side wafer 34 in a small stroke is incorporated into the carriage 43. The elastic guides 44 are formed from an elastic body and are joined on the side surface of the carriage 43. The carriage 43 is connected to the positioning stage 41 by the elastic guides 44. The elastic guides 44 support the carriage 43 so that an undersurface 43a of the carriage 43 does not contact the support surface 42a of the carriage support table 42, when any load is not applied to the carriage 43. At this time, a gap of about 100 µm is formed between the undersurface 43a of the carriage 43 and the support surface 42a of the carriage support table 42. On the other hand, when a load is applied to the carriage 43 in the vertical direction by the upper-side stage mechanism 23, the elastic guides 44 elastically deform so that the undersurface 43a of the carriage 43 contacts the support surface 42a of the carriage support table 42.

In this case, the positioning stage 41 drives the elastic guides 44 and the carriage 43 connected to the elastic guides 44. More specifically, the positioning stage 41 is configured to move to the axial directions of X and Y, and to rotate in an angular direction of θ. For example, a ball screw, a linear guide, and a moving/rotating mechanism (not shown) using a motor are incorporated into the positioning stage 41. The positioning stage 41 functions as the coarse movement stage. The carriage 43 is moved and/or rotated by the positioning stage 41, according to need. Thus, the cartridge 32 put on the carriage 43 (and the lower-side wafer 34 put on the cartridge 32) is moved and/or rotated.

The above-mentioned alignment mechanism 27 is incorporated into the lower-side stage mechanism 24. FIG. 4B is a diagram schematically showing the configuration of a portion of the lower-side stage mechanism 24 that is related to the alignment mechanism 27. The alignment mechanism 27 includes infrared illuminations 101 which generate infrared rays, lenses 102 which change the direction of the infrared rays into the vertical direction, and cameras 103. Moreover, a transparent part 104 is formed in the carriage support table 42 and a transparent part 105 is formed (more specifically, in the stage 52 of the carriage 43 to be mentioned later) in the carriage 43. The transparent parts 104 and 105 are formed of transparent material to the infrared rays irradiated from the infrared illuminations 101. The transparent part 105 of the carriage 43 is arranged in the neighborhood of the transparent part 104 of the carriage support table 42.

The alignment mechanism 27 detects the differences in the position and the orientation between the upper-side wafer 33 and the lower-side wafer 34, by using a transparent part 106 that is provided in the cartridge 32 put on the carriage 43, an alignment mark 107 that is provided on the upper-side wafer 33, and an alignment mark 108 that is provided on the lower-side wafer 34. The transparent part 106 is formed of the transparent material to the infrared rays irradiated from the infrared illuminations 101. In more detail, the lenses 102 changes the irradiation direction of the infrared rays generated by the infrared illuminations 101 to the vertical direction such that the infrared rays are incident on the upper-side wafer 33 and the lower-side wafer 34 through the transparent parts 104, 105, and 106. Note that insulation material (e.g. glass) and semiconductor material (e.g. silicon) which are generally used for the wafer have a property transmitting the infrared rays to an extent at least. Moreover, the lenses 102 lead the infrared rays reflected by the upper-side wafer 33 and the lower-side wafer 34 to the cameras 103. The cameras 103 pick up the reflected infrared rays which have passed through the lenses 102, to provide partial images of the upper-side wafer 33 and the lower-side wafer 34 (that is, the partial images in the neighborhood of the alignment marks 107 and 108). The obtained images are sent to the control unit 3 to be subject to image processing by the control unit 3. The differences in the position and the orientation between the upper-side wafer 33 and the lower-side wafer 34 are detected through the image processing.

Note that a cavity (or a hole) may be disposed to pass the infrared rays, instead of the transparent part 104 of the carriage support table 42. In the same way, cavities (or holes) may be disposed to pass the infrared rays, instead of the transparent parts 105 and 106 of the carriage 43 and cartridge 32. In one example, the transparent part 104 may be disposed in the carriage support table 42 and the cavities may be disposed in the carriage 43 and the cartridge 32 to pass the infrared rays.

Next, the configuration of the carriage 43 will be described in detail. FIG. 5A is a plan view showing the configuration of the carriage 43. The carriage 43 includes a frame 51 and a table 52. The frame 51 is connected to the positioning stage 41 by the above-mentioned elastic guides 44.

The table 52 is used as a lower-side wafer holding section that holds the cartridge 32 put thereon (and the lower-side wafer 34 put on the cartridge 32). The above-mentioned transparent parts 105 are formed in the table 52. As described above, the cavity (or the hole) may be disposed in the table 52 of the carriage 43 to pass the infrared rays, instead of the transparent part 105. The table 52 is surrounded by the frame 51 and is supported to the frame 51 by a plurality of hinge sections 53 to be movable. In the present example, four corners of the table 52 are connected to the frame 51 by the four hinge sections 53.

FIG. 5B is a plan view showing the configuration of the hinge section 53. Each hinge section 53 has fragment members 61 and 62. The fragment member 61 is connected to the table 52 by a narrow section 63 and is connected to the fragment member 62 by a narrow section 64. Also, the fragment member 62 is connected to the frame 51 by a narrow section 65. FIG. 5C is a perspective view showing the configuration of the narrow section 63. The narrow section 63 is configured to have a structure narrow in width, and to be curveable. In the same way, each of the narrow sections 64 and 65 is configured to have a structure narrow in width and to be curveable. The hinge section 53 of such a configuration is connected with the frame 51 to allow the table 52 to move in the axial directions of X and Y, and to rotate in the angular direction of θ. Here, the angular direction of θ is an angular direction in the XY plane.

Referring to FIG. 5A again, the carriage 43 includes three driving mechanisms 54₁ to 54₃ which drive the table 52. The driving mechanisms 54₁ and 54₂ drive the table 52 in the axial direction of X, and the driving mechanism 54₃ drives the table 52 in the axial direction of Y. The three driving mechanisms 54₁ to 54₃ are used as the fine movement mechanism to finely move the table 52.

In detail, the driving mechanism 54₁ includes a piezo-electric device 55₁ and a connection section 56₁. The piezo-electric device 55₁ has one end connected to the frame 51, and the other end connected to a connection section 56₁. The piezo-electric device 55₁ moves the connection section 56₁ in the axial direction of X according to a voltage supplied to it. The connection section 56₁ has one end connected to the piezo-electric device 55₁, and the other end connected to the table 52. Here, the connection section 56₁ is disposed with two narrow sections 57 and can be curved there. In such a configuration, even when the table 52 is driven in the axial direction of Y by the driving mechanism 54₃, the displacement of the table 52 in the axial direction of Y can be absorbed by curving of the narrow section 57.

The driving mechanism 54₂ is configured like the driving mechanism 54₁ and includes a piezo-electric device 55₂ and a connection section 56₂. The piezo-electric device 55₂ has one end connected to the frame 51, and the other end connected to the connection section 56₂. The piezo-electric device 55₂ moves the connection section 56₂ into the axial direction of X according to a voltage supplied to it. The connection section 56₂ has one end connected to the piezo-electric device 55₂, and the other end connected to the table 52. The connection section 56₂ is disposed with two narrow sections and can be curved there. In such a configuration, even when the table 52 is driven in the axial direction of Y by the driving mechanism 54₃, the displacement of the table 52 in the axial direction of Y can be absorbed by curving of the narrow sections of the connection section 56₂.

Moreover, the driving mechanism 54₃ is configured like the driving mechanisms 54₁ and 54₂, excluding the driving direction of the table 52. In detail, the driving mechanism 54₃ includes a piezo-electric device 55₃ and a connection section 56₃. The piezo-electric device 55₃ has one end connected to the frame 51, and the other end connected to the connection section 56₃. The piezo-electric device 55₃ moves the connection section 56₃ in the axial direction of Y according to a voltage supplied to it. The connection section 56₃ has one end connected to the piezo-electric device 55₃, and the other end connected to the table 52. The connection section 56₃ is disposed with two narrow sections and can be curved in the narrow sections. In such a configuration, even when the table 52 is driven to the axial direction of X by the driving mechanisms 54₁ and 54₂, the displacement of the table 52 in the axial direction of X can be absorbed by curving of the narrow sections of the connection section 56₃.

The carriage 43 of such a configuration functions as the fine movement stage that can move the table 52 in the axial directions of X and Y and rotate it in the angular direction of θ. When the table 52 should be moved in the axial direction of X, the voltages are supplied to the piezo-electric devices 55₁ and 55₂ of the driving mechanisms 54₁ and 54₂ such that the piezo-electric devices 55₁ and 55₂ are operated by a same quantity. Thus, by appropriately controlling the voltages supplied to the piezo-electric devices 55₁ and 55₂, it is possible to move the table 52 to a desired position in the axial direction of X. Also, when the table 52 should be moved in the axial direction of Y, the voltages are supplied to the piezo-electric devices 55₁ and 55₂ of the driving mechanisms 54₁ and 54₂ such that the piezo-electric devices 55₁ and 55₂ are operated by an identical quantity. Thus, by appropriately controlling the voltages supplied to the piezo-electric devices 55₁ and 55₂, it is possible to move the table 52 to a desired position in the axial direction of X. Moreover, when the table 52 should be moved in the angular direction of θ, the voltages are supplied to the piezo-electric devices 55₁ and 55₂ of the driving mechanisms 54₁ and 54₂ such that the piezo-electric devices 55₁ and 55₂ are operated by different quantities. By appropriately controlling the voltages supplied to the piezo-electric devices 55₁ and 55₂, it is possible to rotate the table 52 by a desired angle in the angular direction of θ.

The carriage 43 of such a configuration can move or rotate the table 52 in a high precision because the piezo-electric devices 55₁, 55₂ and 55₃ are used for the movement or rotation of the table 52. In other words, the carriage 43 can carry out the positioning of the lower-side wafer 34 which is held by the cartridge 32 put on the table 52 in a high precision.

In the positioning of the lower-side wafer 34 by the lower-side stage mechanism 24 of such a configuration, the positioning stage 41 operates as a coarse movement stage mechanism and the carriage 43 operates as a fine movement stage mechanism. That is, the positioning stage 41 operates as a stage mechanism in which the stroke is large but the precision is low, compared with the carriage 43. The carriage 43 operates as a stage mechanism in which the stroke is small but the precision is high, compared with the positioning stage 41. When the lower-side wafer 34 (and the cartridge 32 which holds the lower-side wafer 34) should be moved or rotated in at least one of the directions of X, Y and θ in a large displacement, the lower-side wafer 34 is moved or rotated by the positioning stage 41. Also, when the lower-side wafer 34 should be moved or rotated in at least one of the directions of X, Y and θ in a small displacement, the lower-side wafer 34 is moved or rotated by the carriage 43. Through such an operation, the lower-side stage mechanism 24 can realize a sufficiently large stroke and the precise positioning of the wafer.

In addition, when the carriage 43 is pressed in the vertically lower direction by the upper-side stage mechanism 23, the undersurface 43a of the carriage 43 contacts the support surface 42a of the carriage support table 42 so that the load is mainly applied to the carriage support table 42. Therefore, the load applied to the positioning stage 41 functioning as the coarse movement stage is reduced. According to such a configuration, the withstand load property of the lower-side stage mechanism 24 can be increased.

Next, the room-temperature bonding method (the operation of the room-temperature bonding apparatus) of the present example will be described. FIG. 6 is a flow chart showing the room-temperature bonding method of the present example. This room-temperature bonding method is performed by using the above-mentioned room-temperature bonding apparatus 1.

In the initial state, it is assumed that the user sets the cartridge 31 having the upper-side wafer 33 thereon on the cartridge stand 12 of the load lock chamber 4 and the cartridge 32 having the lower-side wafer 34 thereon on the cartridge stand 13. When the room-temperature bonding should be carried out to a plurality of upper-side wafers 33 and a plurality of lower-side wafers 34 of the same number, the plurality of cartridges 31 may be set on the cartridge stand 12, and the cartridges 32 of the same number may be set on the cartridge stand 13.

First, the lid of the load lock chamber 4 is closed and a preliminary ambience is generated inside the load lock chamber 4 by the vacuum exhaust unit 11 of the load lock chamber 4 (Step S1). The preliminary ambience is a vacuum ambience of an extent that it is permitted that the load lock chamber 4 and the bonding chamber 5 are communicated through the conveyance passage 6 by opening the gate valve 7.

Next, one sheet of upper-side wafer 33 and one sheet of lower-side wafer 34 are conveyed to the bonding chamber 5 (Step S2). Specifically, the gate valve 7 is opened, and the cartridge 31 having the upper-side wafer 33 is conveyed from the cartridge stand 12 of the load lock chamber 4 onto the table 52 of the carriage 43 of the bonding chamber 5 by the conveyance robot 14. Next, the electrostatic chuck 25 is dropped down by the pressure welding mechanism 26. The dropping operation of the electrostatic chuck 25 is stopped at the timing that the upper-side wafer 33 on the cartridge 31 is in contact with the electrostatic chuck 25. Subsequently, the upper-side wafer 33 is held by the electrostatic chuck 25. Then, the electrostatic chuck 25 is raised to a predetermined standby position by the pressure welding mechanism 26. Next, the cartridge 31 is conveyed from the carriage 43 to the cartridge stand 12 by the conveyance robot 14. After that, the cartridge 32 having the lower-side wafer 34 is conveyed from the cartridge stand 13 onto the table 52 of the carriage 43 by the conveyance robot 14. Subsequently, the gate valve 7 is closed.

Next, an activation ambience is generated inside the bonding chamber 5 (Step S3). More specifically, the degree of vacuum inside the bonding chamber 5 is controlled to about 10⁻⁵ to 10⁻⁶ Pa by the vacuum exhaust unit 21.

Next, the surface of the upper-side wafer 33 and the surface of the lower-side wafer 34 are activated (Step S4). Specifically, an ion beam 22a is irradiated from the ion gun 22 to the surface of the upper-side wafer 33 and the surface of the lower-side wafer 34. Thus, the surface of the upper-side wafer 33 and the surface of the lower-side wafer 34 are etched. During the irradiation of the ion beam 22a, the degree of vacuum inside the bonding chamber 5 becomes about 10⁻² to 10⁻³ Pa.

Next, the positioning of the upper-side wafer 33 and the lower-side wafer 34 is carried out by the upper-side stage mechanism 23 and the lower-side stage mechanism 24 (Step S5). Specifically, the electrostatic chuck 25 is dropped down by the pressure welding mechanism 26 of the upper-side stage mechanism 23, such that the electrostatic chuck 25 is arranged at a predetermined alignment position. At this time, the upper-side wafer 33 and the lower-side wafer 34 are away from each other by a predetermined alignment distance. Moreover, the lower-side wafer 34 is moved and/or rotated by the lower-side stage mechanism 24 and the alignment with the upper-side wafer 33 is carried out in a horizontal plane.

In one example, the alignment between the upper-side wafer 33 and the lower-side wafer 34 is carried out according to the following procedure. First, an positional deviation quantity between the alignment marks 107 and 108 of the upper-side wafer 33 and the lower-side wafer 34 (positional deviation quantities in the axial direction of X and the axial direction of Y) and an orientational deviation quantity (a deviation in the angular direction of θ) are calculated by using the alignment mechanism 27 disposed in the bonding chamber 5. The positional deviation quantities are calculated as a positional difference between the alignment marks 107 and 108 and the orientational deviation quantity is calculated as an angular difference between the alignment marks 107 and 108. When all of the positional deviation quantities and the orientational deviation quantity between the alignment marks fall within a reference range, the alignment of the upper-side wafer 33 and the lower-side wafer 34 is ended.

On the other hand, when at least one of the positional deviation quantities and the orientational deviation quantity between the alignment marks is out of the reference range, the lower-side stage mechanism 24 moves or rotates the lower-side wafer 34 to cancel the at least one deviation quantity. At this time, each of the coarse movement of the lower-side wafer 34 by the positioning stage 41 and the fine movement of the lower-side wafer 34 by the driving mechanisms 54₁ to 54₃ of the carriage 43 is selectively carried out according to the positional deviation quantities and the orientational deviation quantity between the alignment marks. In detail, when at least one of the positional deviation quantities and the orientational deviation quantity between the alignment marks is larger than a corresponding one of thresholds for these deviation quantities, the carriage 43 is driven by the positioning stage 41 so as to move or rotate the carriage 43. On the other hand, when both of the positional deviation quantities and the orientational deviation quantity between the alignment marks are smaller than corresponding thresholds, the table 52 is driven by the driving mechanisms 54₁ to 54₃ of the carriage 43. Thus, the lower-side wafer 34 put on the cartridge 32 which has been held on the table 52 is driven to cancel the positional deviation quantities and the orientational deviation quantity between the alignment markers. After the carriage 43 or the table 52 is moved and/or rotated, a procedure of detecting the positions of the alignment marks and an angle between the alignment marks is repeatedly carried out until both of the positional deviation quantities and the orientational deviation quantity between the alignment marks fall within the reference range.

Next, the upper-side wafer 33 and the lower-side wafer 34 are brought into contact with each other and are bonded to each other (Step S6). Specifically, the electrostatic chuck 25 is dropped down by the pressure welding mechanism 26 such that the surface of the upper-side wafer 33 is brought into contact with the surface of the lower-side wafer 34. The dropping operation of the electrostatic chuck 25 is stopped at the timing that the load applied to the electrostatic chuck 25 reaches a predetermined bonding load. That is, the bonding load is applied to the upper-side wafer 33 and the lower-side wafer 34. The upper-side wafer 33 and the lower-side wafer 34 are bonded by applying the bonding load, to form one sheet of the bonded wafer. The application of the bonding load to the bonded wafer continues for a predetermined bonding time.

At this time, the load is applied to the table 52 of the carriage 43 in the vertically lower direction. When the load is applied to the table 52, the elastic guides 44 are deformed elastically, such that the undersurface 43a of the carriage 43 contacts the support surface 42a of the carriage support table 42. As a result, the load applied to the table 52 is mainly applied to the carriage support table 42, while the load applying on the positioning stage 41 is reduced. This means that the withstand load property of the lower-side stage mechanism 24 can be increased.

Next, the bonded wafer is conveyed to the load lock chamber 4 (Step S7). Specifically, after the bonded wafer is separated from the electrostatic chuck 25, the electrostatic chuck 25 is raised by the pressure bonding mechanism 26. At this time, the bonded wafer is left in the state that it is put on the cartridge 32. After that, when the gate valve 7 is opened, the cartridge 32 on which the bonded wafer has been put on is conveyed from the table 52 of the carriage 43 to the load lock chamber 4 by the conveyance robot 14 and then is returned to the cartridge stand 13.

When the cartridge 31 having the upper-side wafer 33 which has not been yet bonded and the cartridge 32 having the lower-side wafer 34 which has not been yet bonded remain on the cartridge stands 12 and 13 (step S8, YES), the operation of step S2 to step S7 is carried out once again.

On the other hand, when the bonding of all of the upper-side wafers 33 and the lower-side wafer 34 has completed (Step S8, NO), the vacuum exhaust unit 11 of the load lock chamber 4 is controlled to generate an atmospheric ambience inside the load lock chamber 4 (Step S9). Thus, the user can open the lid of the load lock chamber 4 and take out the cartridge 32 on which the bonded wafer has been put and the cartridge 31 having no wafer from the cartridge stands 12 and 13. Through the above-mentioned steps, the procedure of the bonding of the upper-side wafer 33 and the lower-side wafer 34 completes. Note that the above-mentioned steps S1 to S9 are realized by executing a computer program 36a by the control unit 3.

As described above, in the present example, the positioning stage 41 of the lower-side stage mechanism 24 operates as the coarse movement stage mechanism in which the lower-side wafer 34 is coarsely moved, and the carriage 43 operates as the fine movement stage mechanism in which the lower-side wafer 34 is finely moved. Through such operations, the lower-side stage mechanism 24 can realize a sufficiently large stroke and precise positioning of the wafer.

In addition, when the carriage 43 is pressed in the vertically lower direction by the upper-side stage mechanism 23, the elastic guides 44 which support the carriage 43 are deformed elastically so that the undersurface 43a of the carriage 43 contacts the support surface 42a of the carriage support table 42. As a result, the load is mainly applied to the carriage support table 42. Therefore, the load applied to the positioning stage 41 which functions as the coarse movement stage mechanism is reduced. According to such a configuration, the withstand load property of the lower-side stage mechanism 24 can be increased.

### [Embodiment]

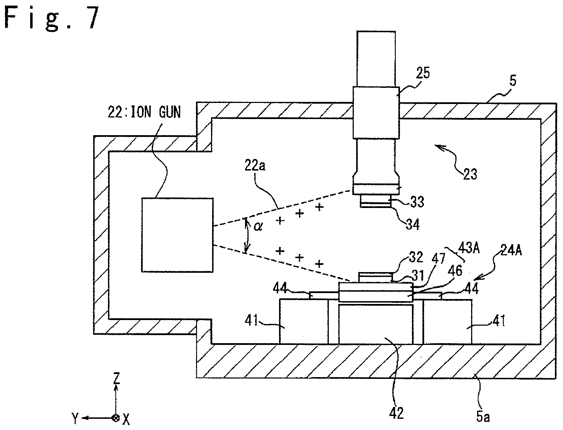

FIG. 7 is a sectional view schematically showing the configuration of the room-temperature bonding apparatus 1 according to an embodiment of the present invention, especially, the configuration of a lower-side stage mechanism 24A. The configuration of the room-temperature bonding apparatus 1 of the embodiment is almost same as that of the room-temperature bonding apparatus 1 of the first example. However, the configuration of the lower-side stage mechanism 24A is different from the configuration of the lower-side stage mechanism 24 of the first example. Note that the alignment mechanism 27 may be incorporated into the lower-side stage 24A, like the first example, but is not shown in FIG. 7.

In detail, in the embodiment, a carriage 43A of the lower-side stage mechanism 24A includes a carriage plate 46 and a fine movement stage 47 mounted on the carriage plate 46. The carriage plate 46 is connected to the positioning stage 41 by the elastic guides 44. As described above, the positioning stage 41 functions as the coarse movement stage having a large stroke. The carriage plate 46 has a smooth upper surface and a smooth undersurface. The elastic guides 44 support the carriage plate 46 so as for the lower surface of the carriage plate 46 not to contact the support surface 42a of the carriage support table 42, when a load is not applied to the carriage 43A. At this time, a gap of about 100 µm is provided between the undersurface of the carriage plate 46 and the support surface 42a of the carriage support table 42. On the other hand, when a load is applied to the carriage 43A in the vertically lower direction by the upper-side stage mechanism 23, the elastic guides 44 elastically deform so that the undersurface of the carriage plate 46 contacts the support surface 42a of the carriage support table 42.

The fine movement stage 47 has the same configuration as the carriage 43 shown in FIG. 5A to FIG. 5C (in this case, the frame 51 is not directly connected to the elastic guides 44). The fine movement stage 47 includes the frame 51 and the table 52. The table 52 is used as a lower-side wafer holding section having the cartridge 32 put thereon (and the lower-side wafer 34 put on the cartridge 32). The table 52 is surrounded by the frame 51 and is movably supported to the frame 51 by the four hinge sections 53. Moreover, the fine movement stage 47 includes three driving mechanisms 54₁ to 54₃ which drive the table 52. The driving mechanisms 54₁ and 54₂ drive the table 52 in the axial direction of X and the driving mechanism 54₃ drives the table 52 in the axial direction of Y. The undersurfaces of the frame 51 and table 52 of the fine movement stage 47 are bonded to the surface of the carriage plate 46.

The configuration of the lower-side stage mechanism 24A of the present embodiment can satisfy the requests of the precise positioning of the wafer and the large withstand load property, while providing a sufficiently large stroke, like the first example. In the present embodiment, the positioning stage 41 of the lower-side stage mechanism 24A operates as the coarse movement stage mechanism coarsely moving the lower-side wafer 34 while the fine movement stage 47 of the carriage 43A is used to finely move the lower-side wafer 34. By such an operation, the lower-side stage mechanism 24 can realize the sufficiently large stroke and the precise positioning of the wafer.

In addition, when the carriage 43A is dropped down in the vertically lower direction by the upper-side stage mechanism 23, the elastic guides 44 supporting the carriage plate 46 deform elastically so that the undersurface of the carriage plate 46 contacts the support surface 42a of the carriage support table 42. As a result, the load is mainly applied to the carriage support table 42. Therefore, the load applied to the positioning stage 41 functioning as the coarse movement stage mechanism is reduced and it is possible to increase the withstand load property of the lower-side stage mechanism 24.

FIG. 8 is a sectional view schematically showing the configuration of the lower-side stage mechanism 24A in a modification example of the room-temperature bonding apparatus 1 according to the embodiment. In the modification example, the table 52 of the fine movement stage 47 is supported by the hinge sections 53 to be movable in an upper and lower direction (the axial direction of Z). When a load is not applied to the table 52, the table 52 is supported such that there is a gap between the undersurface of the table 52 and the upper surface of the carriage plate 46. The configuration having the gap between the undersurface of the table 52 and the upper surface of the carriage plate 46 is effective in that it is possible to make the operation of the fine movement stage 47 smooth and to prevent a precision drop, because the table 52 never grazes the carriage plate 46 when the table 52 moves. Also, it is possible to restrain the generation of particles when the table 52 grazes the carriage plate 46.

Here, in the modification example, when the table 52 of the fine movement stage 47 is pushed in the vertically lower direction by the upper-side stage mechanism 23 such that a load is applied to the table 52, the hinge sections 53 supporting the table 52 deform elastically so that the undersurface 52a of the table 52 is brought into contact with the upper surface 46a of the carriage plate 46. At this time, the carriage plate 46 is also pushed in the vertically lower direction so that the undersurface of the carriage plate 46 is brought into contact with the support surface 42a of the carriage support table 42. Thus, the load is mainly applied to the carriage support table 42. In the configuration of this modification example, because the load is mainly applied to the carriage support table 42, the load acting on the hinge sections 53 of the fine movement stage 47 is reduced so that the damaging of the hinge sections 53 can be prevented.

### [Second Example]

FIG. 9 is a sectional view schematically showing the configuration of the room-temperature bonding apparatus 1 according to a second example serving to explain aspects of the present invention, especially, the configuration of the lower-side stage mechanism 24B. The configuration of the room-temperature bonding apparatus 1 of the second example is similar to that of the room-temperature bonding apparatus 1 of the first example and the embodiment. However, the configuration of the lower-side stage mechanism 24B is different from the configurations of the lower-side stage mechanism 24 of the first example and the lower-side stage mechanism 24A of the embodiment. Note that the alignment mechanism 27 may be incorporated into the lower-side stage 24B, like the first example, but is not shown in FIG. 9.

In the second example, the lower-side stage mechanism 24B includes the positioning stage 41, the carriage support table 42, a fine movement stage 71, a carriage 72 and an elastic guide 73. Like the first example and the embodiment, the positioning stage 41 functions as the coarse movement stage having a large stroke. The carriage support table 42 has the smooth support surface 42a as the upper end. The support surface 42a is perpendicular to the upper and lower direction (the axial direction of Z).

The fine movement stage 71 has the configuration similar to the carriage 43 (fine movement stage 47) shown in FIG. 5A to FIG. 5C. As shown in FIG. 10, the fine movement stage 71 includes the frame 51 and the table 52. The table 52 is used as the wafer holding section that holds the cartridge 32 put thereon (and the lower-side wafer 34 put on the cartridge 32). The table 52 is arranged to be surrounded by the frame 51, and is supported to the frame 51 by four hinge sections 53. Moreover, the fine movement stage 47 includes three driving mechanisms 54₁ to 54₃ for driving the table 52. The driving mechanisms 54₁ and 54₂ drive the table 52 to the axial direction of X, and the driving mechanism 54₃ drives the table 52 to the axial direction of Y. The frame 51 of the fine movement stage 47 is joined to the surface of the positioning stage 41.

The carriage 72 functions as the lower-side wafer holding section that holds the cartridge 32 put thereon (and the lower-side wafer 34 put on the cartridge 32). The elastic guide 73 is formed of elastic body and is joined to the side surface of the carriage 72. The carriage 72 is connected to the table 52 of the fine movement stage 71 by the elastic guide 73. The elastic guide 73 supports the carriage 72 so as for the lower surface 72a of the carriage 72 not to contact the support surface 42a of the carriage support table 42 when any load is not applied to the carriage 72. At this time, a gap of about 100 µm is provided between an undersurface 72a of the carriage 72 and the support surface 42a of the carriage support table 42. On the other hand, when a load is applied to the carriage in the vertically lower direction 72 by the upper-side stage mechanism 23, the elastic guide 73 deforms elastically for the undersurface 72a of the carriage 72 to contact the support surface 42a of the carriage support table 42.

The configuration of the lower-side stage mechanism 24B in the present example can satisfy the requests of the precise positioning of the wafer and the large withstand load property while providing the sufficiently large stroke, like the first example. In the second example, the positioning stage 41 of the lower-side stage mechanism 24B functions as the coarse movement stage mechanism which coarsely moves the lower-side wafer 34. That is, the positioning stage 41 moves and/or rotates the fine movement stage, by driving the whole fine movement stage 71, when the coarse movement of the lower-side wafer 34 should be carried out. Because the carriage 72 that holds the lower-side wafer 34 is connected to the table 52 of the fine movement stage 71 by the elastic guide 73, the lower-side wafer 34 can be moved by moving the whole fine movement stage 71. On the other hand, the fine movement stage 71 is used to move the lower-side wafer 34. When the lower-side wafer 34 should be finely moved, the driving mechanisms 54₁ to 54₃ of the fine movement stage 71 move and/or rotate the table 52. Because the carriage 72 that holds the lower-side wafer 34 is connected to the table 52 by the elastic guide 73, the lower-side wafer 34 can be moved by moving the table 52. By such an operation, the lower-side stage mechanism 24B can realize a sufficiently large stroke and the precise positioning of the wafer.

In addition, when the carriage 72 is pushed down in the vertically lower direction by the upper-side stage mechanism 23, the elastic guide 73 supporting the carriage 72 deforms elastically such that the undersurface 72a of the carriage 72 is brought into contact with the support surface 42a of the carriage support table 42. As a result, the load is mainly applied to the carriage support table 42. It should be noted that in the present example, the effect is obtained that the load applied to the fine movement stage 71 can be reduced, in addition to the reducing of the load applied to the positioning stage 41 that functions as the coarse movement stage mechanism. This contributes the increase of the withstand load property of the lower-side stage mechanism 24B.

### (Modification example of upper-side stage mechanism)

In each of the above-mentioned embodiment and examples, although the upper-side stage mechanism 23 has only the function of moving the electrostatic chuck 25 in the upper and lower direction, an angle adjustment mechanism may be incorporated into the upper-side stage mechanism to adjust the orientation of the electrostatic chuck holding the upper-side wafer 33 (the upper-side wafer holding section). FIG. 11 is a side view schematically showing the configuration of an upper-side stage mechanism 23A having such a configuration.

As shown in FIG. 11, the upper-side stage mechanism 23A has an elevation rod 81 that moves in the upper and lower direction. The electrostatic chuck 83 is installed at the bottom end of the elevation rod 81 to hold the upper-side wafer 33 through the angle adjustment mechanism 82. The angle adjustment mechanism 82 includes a spherical seat 84 connected to the bottom end of the elevation rod 81, a fixation flange 85 and a spherical flange 86 attached to the electrostatic chuck 83. The spherical flange 86 has a supporting section and a flange section. The supporting section is joined to the electrostatic chuck 83. The flange section is formed as a sphere having a point 86a as a center. On the other hand, the spherical seat 84 has a spherical seat surface to tightly fit to the flange section of the spherical flange 86. The fixation flange 85 is joined to the spherical seat 84 with a fastening member such as a bolt, and supports the flange section of the spherical flange 86 to make the flange section tightly fit to the spherical seat surface of the spherical seat 84. The flange section of spherical flange 86 is slidably connected to the spherical seat surface of the spherical seat 84 with the fixation flange 85.

FIG. 12 is a perspective view showing the configuration of the fixation flange 85. The fixation flange 85 includes divisional rings 87a and 87b. The divisional rings 87a and 87b have the shapes of parts of a ring, respectively. The divisional rings 87a and 87b are respectively connected to the spherical seat 84 by the fastening member such as a bolt. The divisional rings 87a and 87b are arranged to contact the flange section of the spherical flange 86 in its inner side to support the flange section therebetween.

By supporting the electrostatic chuck 83 that holds the upper-side wafer 33 by using the angle adjustment mechanism 82 having such a configuration, the upper-side wafer 33 and the lower-side wafer 34 can be bonded while maintaining a parallelism between the upper-side wafer 33 and the lower-side wafer 34. This is effective to apply a large bonding load uniformly to the upper-side wafer 33 and the lower-side wafer 34.

### [Explanation of the code]

- 1:: room-temperature bonding apparatus
- 2:: process module
- 3:: control unit
- 4:: load lock chamber
- 5:: bonding chamber
- 5 a:: bottom board
- 6:: conveyance passage
- 7:: gate valve
- 11:: vacuum exhaust unit
- 12:: cartridge stand
- 13:: cartridge stand
- 14:: conveyance robot
- 21:: vacuum exhaust unit
- 22:: ion gun
- 22a:: ion beam
- 23, 23A:: upper-side stage mechanism
- 24, 24A, 24B:: lower-side stage mechanism
- 25:: electrostatic chuck
- 26:: pressure welding mechanism
- 27:: alignment mechanism
- 27a:: optical system
- 27b:: image pickup device
- 27c:: image processing apparatus
- 31, 32:: cartridge
- 33:: upper-side wafer
- 34:: lower-side wafer
- 36a:: computer program
- 41:: positioning stage
- 42:: carriage support base
- 42a:: support surface
- 43, 43A:: carriage
- 43a:: lower surface
- 44:: elastic guide
- 46:: carriage plate
- 46a:: surface
- 47:: fine movement stage
- 51:: frame
- 52:: table
- 52a:: lower surface
- 53:: hinge section
- 54₁, 54₂, 54₃:: driving mechanism
- 55₁, 55₂, 55₃:: piezo-electric device
- 56₁, 56₂, 56₃:: connection section
- 57:: narrow section
- 61, 62:: fragment member
- 63, 64, 65:: narrow section
- 71:: fine movement stage
- 72:: carriage
- 72a:: lower surface
- 73:: elastic guide
- 81:: elevation rod
- 82:: angle adjustment mechanism
- 83:: electrostatic chuck
- 84:: spherical seat
- 85:: fixation flange
- 86:: spherical flange
- 86a:: point
- 87a, 87b:: divisional ring
- 91:: CPU
- 92:: memory
- 93:: input unit
- 94:: output unit
- 95:: interface
- 96:: external storage unit
- 96a:: computer program
- 97:: drive
- 98:: recording medium
- 101:: infrared illumination
- 102:: lens
- 103:: camera
- 104, 105, 106:: transparent part
- 107, 108:: alignment mark

## Claims

1. A room-temperature bonding apparatus (1) comprising:
a bonding chamber (5);
an upper-side stage mechanism (23) configured to support an upper-side wafer (33) in the bonding chamber (5) to be movable in an upper and lower direction;
a lower-side stage mechanism (24) configured to support a lower-side wafer (34) in the bonding chamber (5) to be movable in a horizontal plane;
an aligning mechanism (27) incorporated into the lower-side stage mechanism (24) and configured to pick up an image of an alignment mark (107) formed on a surface of the upper-side wafer (33) held by the upper-side stage mechanism (23) and an image of an alignment mark (108) formed on a surface of the lower-side wafer (34) put on the lower-side stage mechanism (24); and
a control unit (3) configured to detect a difference in a position and in an orientation between the upper-side wafer (33) and the lower-side wafer (34) through image processing of the images of the alignment marks (107,108) picked up by the aligning mechanism (27),
wherein the lower-side stage mechanism (24) comprises:
a carriage (43;43A) having a lower-side wafer holding section configured to hold the lower-side wafer (34);
an elastic guide (44;73) connected to the carriage (43;43A) to support the carriage (43;43A);
a positioning stage (41) configured to coarsely move the lower-side wafer holding section under the control of the control unit (3) according to the detected difference in position and orientation;
and
a carriage support base (42),
wherein the elastic guide (44;73) supports the carriage (43;43A) such that the carriage (43;43A) does not contact the carriage support base (42) when no load is applied to the carriage (43;43A) from the upper-side stage mechanism (23), and is configured to elastically deform such that the carriage (43;43A) contacts the carriage support base (42), when the upper-side wafer (33) contacts the lower-side wafer (34) and a load is applied to the carriage (43;43A) in an upper and lower direction by the upper-side stage mechanism (23),
**characterized in that**
the lower-side stage mechanism (24) comprises a fine movement mechanism configured to finely move the lower-side wafer holding section under the control of the control unit (3) according to the detected difference in position and orientation; and
a transparent part (105) is formed in the fine movement mechanism so that the aligning mechanism (27) can pick up the image of the alignment mark (107) formed on the surface of the upper-side wafer (33),
wherein the positioning stage (41) is configured to drive the elastic guide (44;73) to coarsely move the lower-side wafer holding section,
wherein the fine movement mechanism is incorporated into the carriage (43;43A),
wherein the carriage (43A) comprises a carriage plate (46) to which the elastic guide (44) is joined,
wherein the lower-side wafer holding section is arranged above the carriage plate (46),
wherein the fine movement mechanism comprises:
a frame (51) disposed on the carriage plate (46); and
a driving mechanism (54) connected to the frame (51) to drive the lower-side wafer holding section, and
wherein, when the upper-side stage mechanism (23) brings the upper-side wafer (33) into contact with the lower-side wafer (34) and applies the load to the carriage (43A) in the upper and lower direction, the elastic guide (44) is configured to elastically deform such that the carriage plate (46) contacts the carriage support base (42).

2. The room-temperature bonding apparatus (1) according to claim 1, wherein a support mechanism is disposed in the frame (51) to movably support the lower-side wafer holding section in the upper and lower direction, and
wherein the support mechanism supports the lower-side wafer holding section such that the lower-side wafer holding section does not contact the carriage plate (46) when any load is not applied to the lower-side wafer holding section from the upper-side stage mechanism (23), and is configured to elastically deform such that the lower-side wafer holding section contacts the carriage plate (46) when the upper-side stage mechanism (23) brings the upper-side wafer (33) into contact with the lower-side wafer (34) and applies a load to the lower-side wafer holding section in the upper and lower direction.

3. The room-temperature bonding apparatus (1) according to claim 1 or 2, wherein the upper-side stage mechanism (23A) comprises:
an upper-side wafer holding section configured to hold the upper-side wafer (33); and
an angle adjustment mechanism (82) configured to adjust an orientation of the upper-side wafer holding section.

4. The room-temperature bonding apparatus (1) according to claim 3, wherein the upper-side stage mechanism (23A) further comprises an elevation rod (81) configured to move in the upper and lower direction, and
the angle adjustment mechanism (82) comprises:
a spherical flange (86) fixed to the upper-side wafer holding section;
a spherical seat (84) fixed to the elevation rod (81); and
a fixation flange (85) fixed to the spherical seat (84), and configured to connect the spherical flange (86) to the spherical seat (84) by supporting the spherical flange (85) therein.

## Patentansprüche

1. Eine Raumtemperatur-Bondingvorrichtung (1) mit:
einer Bondingkammer (5),
einem oberseitigen Tischmechanismus (23), der konfiguriert ist, um einen oberseitigen Wafer (33) in der Bondingkammer (5) in einer Auf-und-Ab-Richtung bewegbar zu tragen,
einem unterseitigen Tischmechanismus (24), der konfiguriert ist, um einen unterseitigen Wafer (34) in der Bondingkammer (5) in einer horizontalen Ebene bewegbar zu tragen,
einem Ausrichtmechanismus (27), der in dem unterseitigen Tischmechanismus (24) enthalten ist, und der konfiguriert ist, um ein Bild einer Ausrichtmarkierung (107), die auf einer Oberfläche des oberseitigen Wafers (33) ausgebildet ist, der durch den oberseitigen Tischmechanismus (23) gehalten ist, und ein Bild einer Ausrichtmarkierung (108), die auf einer Oberfläche des unterseitigen Wafers (34) ausgebildet ist, der auf den unterseitigen Tischmechanismus (24) gesetzt ist, aufzunehmen, und
einer Steuereinheit (3), die konfiguriert ist, um eine Differenz in einer Position und in einer Orientierung zwischen dem oberseitigen Wafer (33) und dem unterseitigen Wafer (34) durch Bildbearbeitung der Bilder der Ausrichtmarkierungen (107,108), die von dem Ausrichtmechanismus (27) aufgenommen wurden, zu erfassen,
wobei der unterseitige Tischmechanismus (24) aufweist:
einen Schlitten (43;43A) mit einem unterseitigen Wafer-Halteabschnitt, der konfiguriert ist, um den unterseitigen Wafer (34) zu halten,
eine elastische Führung (44;73), die mit dem Schlitten (43;43A) verbunden ist, um den Schlitten (43;43A) zu tragen,
einen Positionierungstisch (41), der konfiguriert ist, um den unterseitigen Wafer-Halteabschnitt unter der Steuerung der Steuereinheit (3) gemäß der erfassten Differenz in der Position und der Orientierung grob zu bewegen, und
eine Schlitten-Tragbasis (42),
wobei die elastische Führung (44;73) den Schlitten (43;43A) so trägt, dass der Schlitten (43;43A) die Schlitten-Tragbasis (42) nicht berührt, wenn keine Last auf dem Schlitten (43;43A) von dem oberseitigen Tischmechanismus (23) ausgeübt wird, und sie konfiguriert ist, um sich elastisch zu verformen, sodass der Schlitten (43;43A) die Schlitten-Tragbasis (42) berührt, wenn der oberseitige Wafer (33) den unterseitigen Wafer (34) berührt und eine Last auf den Schlitten (43;43A) in einer Auf-und-Ab-Richtung durch den oberseitigen Tischmechanismus (23) ausgeübt wird,
**dadurch gekennzeichnet, dass**
der unterseitige Tischmechanismus (24) einen Feinbewegungsmechanismus aufweist, der konfiguriert ist, um den unterseitigen Wafer-Halteabschnitt unter der Steuerung der Steuereinheit (3) gemäß der erfassten Differenz in der Position und der Orientierung fein zu bewegen und,
ein transparentes Teil (105) in dem Feinbewegungsmechanismus so ausgebildet ist, dass der Ausrichtmechanismus (27) das Bild der Ausrichtmarkierung (107), das auf der Oberfläche des oberseitigen Wafers (33) ausgebildet ist, aufnehmen kann,
wobei der Positionierungstisch (41) konfiguriert ist, um die elastische Führung (44;73) anzutreiben, um den unterseitigen Wafer-Halteabschnitt grob zu bewegen,
wobei der Feinbewegungsmechanismus in dem Schlitten (43;43A) enthalten ist,
wobei der Schlitten (43A) eine Schlittenplatte (46) aufweist, mit der die elastische Führung (44) verbunden ist,
wobei der unterseitige Wafer-Halteabschnitt über der Schlittenplatte (46) angeordnet ist,
wobei der Feinbewegungsmechanismus aufweist:
einen Rahmen (51), der an bzw. auf der Schlittenplatte (46) angeordnet ist, und
einen Antriebsmechanismus (54), der mit dem Rahmen (51) zum Antreiben des unterseitigen Wafer-Halteabschnitts verbunden ist, und
wobei, wenn der oberseitige Tischmechanismus (23) den oberseitigen Wafer (33) in Kontakt mit dem unterseitigen Wafer (34) bringt und die Last auf den Schlitten (43A) in der Auf-und-Ab-Richtung ausübt, die elastische Führung (44) konfiguriert ist, um sich elastisch zu verformen, sodass die Schlittenplatte (46) die Schlitten-Tragbasis (42) berührt.

2. Die Raumtemperatur-Bondingvorrichtung (1) gemäß Anspruch 1, wobei ein Tragmechanismus in dem Rahmen (51) angeordnet ist, um den unterseitigen Wafer-Halteabschnitt in der Auf-und-Ab-Richtung bewegbar zu tragen, und
wobei der Tragmechanismus den unterseitigen Wafer-Halteabschnitt so trägt, dass der unterseitige Wafer-Halteabschnitt die Schlittenplatte (46) nicht berührt, wenn keine Last auf den unterseitigen Wafer-Halteabschnitt von dem oberseitigen Tischmechanismus (23) ausgeübt wird, und er konfiguriert ist, um sich elastisch zu verformen, sodass der unterseitige Wafer-Halteabschnitt die Schlittenplatte (46) berührt, wenn der oberseitige Tischmechanismus (23) den oberseitigen Wafer (33) in Kontakt mit dem unterseitigen Wafer (34) bringt und eine Last auf den unterseitigen Wafer-Halteabschnitt in der Auf-und-Ab-Richtung ausübt.

3. Die Raumtemperatur-Bondingvorrichtung (1) gemäß Anspruch 1 oder 2, wobei der oberseitige Tischmechanismus (23A) aufweist:
einen oberseitigen Wafer-Halteabschnitt, der konfiguriert ist, um den oberseitigen Wafer (33) zu halten, und
einen Winkeleinstellmechanismus (82), der konfiguriert ist, um eine Orientierung des oberseitigen Wafer-Halteabschnitts einzustellen.

4. Die Raumtemperatur-Bondingvorrichtung (1) gemäß Anspruch 3, wobei der oberseitige Tischmechanismus (23A) ferner eine Anhebestange (81) aufweist, die konfiguriert ist, um sich in der Auf-und-Ab-Richtung zu bewegen, und
der Winkeleinstellmechanismus (82) aufweist:
einen sphärischen Flansch (86), der an dem oberseitigen Wafer-Halteabschnitt befestigt ist,
einen sphärischen Sitz (84), der an der Anhebestange (81) befestigt ist, und
einen Befestigungsflansch (85), der an dem sphärischen Sitz (84) befestigt ist, und der konfiguriert ist, um den sphärischen Flansch (86) mit dem sphärischen Sitz (84) durch Tragen des sphärischen Flansches (85) darin zu verbinden.

## Revendications

1. Dispositif (1) de liaison à température ambiante, comprenant :
une chambre (5) de liaison ;
un mécanisme (23) d'étage du côté supérieur configuré pour supporter une pastille (33) du côté supérieur dans la chambre (5) de liaison pour qu'elle soit mobile dans un sens vers le haut et vers le bas ;
un mécanisme (24) d'étage de côté inférieur configuré pour supporter une pastille (34) de côté inférieur dans la chambre (5) de liaison pour qu'elle soit mobile dans un plan horizontal ;
un mécanisme (27) d'alignement incorporé au mécanisme (24) d'étage du côté inférieur et configuré pour prendre une image d'un repère (107) d'alignement formé sur une surface de la pastille (33) de côté supérieur maintenue par le mécanisme (23) d'étage du côté supérieur et une image d'un repère (108) d'alignement formé sur une surface de la pastille (34) de côté inférieur mise sur le mécanisme (24) d'étage du côté inférieur et
une unité (3) de commande configurée pour détecter une différence de position et d'orientation entre la pastille (33) de côté supérieur et la pastille (34) de côté inférieur par un traitement des images des repères (107, 108) d'alignement pris par le mécanisme (27) d'alignement,
dans lequel le mécanisme (24) d'étage du côté inférieur comprend :
un chariot (43; 43A) ayant une partie de maintien de la pastille de côté inférieur configuré pour maintenir la pastille (34) de côté inférieur ;
une glissière (44; 73) élastique reliée au chariot (43; 43A) pour supporter le chariot (43; 43A) ;
un étage (41) de mise en position configuré pour déplacer grossièrement la partie de maintien de la pastille de côté inférieur sous la commande de l'unité (3) de commande en fonction de la différence détectée de position et d'orientation ;
et
un socle (42) de support de chariot,
dans lequel la glissière (44; 73) élastique supporte le chariot (43; 43A), de manière à ce que le chariot (43; 43A) n'entre pas en contact avec le socle (42) de support du chariot, lorsqu'une charge n'est pas appliquée au chariot (43; 43A) à partir du mécanisme (23) d'étage du côté supérieur, et est configurée pour se déformer élastiquement, de manière à ce que le chariot (43; 43A) entre en contact avec le socle (42) de support du chariot, lorsque la pastille (33) de côté supérieur entre en contact avec la pastille (34) de côté inférieur et lorsqu'une charge est appliquée au chariot (43; 43A) dans un sens vers le haut et vers le bas par le mécanisme (23) d'étage du côté supérieur,
**caractérisé en ce que**
le mécanisme (24) d'étage du côté inférieur comprend un mécanisme de déplacement fin configuré pour déplacer finement la partie de maintien de la pastille de côté inférieur sous la commande de l'unité (3) de commande en fonction de la différence détectée de position et d'orientation et
une partie (105) transparente est formée dans le mécanisme de déplacement fin, de manière à ce que le mécanisme (27) d'alignement puisse prendre l'image du repère (107) d'alignement formé sur la surface de la pastille (33) de côté supérieur,
dans lequel l'étage (41) de mise en position est configurée pour entraîner la glissière (44; 73) élastique, afin qu'elle déplace grossièrement la partie de maintien de la pastille de côté inférieur,
dans lequel le mécanisme de mouvement fin est incorporé au chariot (43; 43A),
dans lequel le chariot (43; 43A) comprend une plaque (46) de chariot, à laquelle la glissière (44) élastique est jointe,
dans lequel la partie de maintien de la pastille de côté inférieur est disposée au-dessus de la plaque (46) du chariot,
dans lequel le mécanisme de déplacement fin comprend :
un bâti (51) disposé sur la plaque (46) du chariot et
un mécanisme (54) d'entraînement relié au bâti (51) pour entraîner la partie de maintien de la pastille de côté inférieur et
dans lequel, lorsque le mécanisme (23) d'étage du côté supérieur met la pastille (33) de côté supérieur en contact avec la pastille (34) de côté inférieur et applique la charge au chariot (43A) dans la direction vers le haut et vers le bas, la glissière (44) élastique est configurée pour se déformer élastiquement, de manière à ce que la plaque (46) du chariot entre en contact avec le socle (42) de support de chariot.

2. Dispositif (1) de liaison à la température ambiante suivant la revendication 1, dans lequel un mécanisme de support est disposé dans le bâti (51) pour supporter, de manière mobile, la partie de maintien de la pastille de côté inférieur dans le sens vers le haut et vers le bas et
dans lequel le mécanisme de support supporte la partie de maintien de la pastille de côté inférieur, de manière à ce que la partie de maintien de la pastille de côté inférieur n'entre pas en contact avec la plaque (46) du chariot, lorsqu'une charge n'est pas appliquée à la partie de maintien de la pastille de côté inférieur à partir du mécanisme (23) d'étage du côté supérieur, et est configuré pour se déformer élastiquement, de manière à ce que la partie de maintien de la pastille de côté inférieur entre en contact avec la plaque (46) du chariot, lorsque le mécanisme (23) d'étage du côté supérieur met la pastille (33) de côté supérieur en contact avec la pastille (34) de côté inférieur et applique une charge à la partie de maintien de la pastille de côté inférieur dans la direction vers le haut et vers le bas.

3. Dispositif (1) de liaison à la température ambiante suivant la revendication 1 ou 2, dans lequel le mécanisme (23A) d'étage de côté supérieur comprend :
une partie de maintien de la pastille de côté supérieur configurée pour maintenir la pastille (33) de côté supérieur et
un mécanisme (82) de réglage d'angle configuré pour régler une orientation de la partie de maintien de la pastille de côté supérieur.

4. Dispositif (1) de liaison à la température ambiante suivant la revendication 3, dans lequel le mécanisme (23) d'étage de côté supérieur comprend, en outre, une barre (81) d'élévation configurée pour se déplacer dans la direction vers le haut et vers le bas et
le mécanisme (82) de réglage d'angle comprend :
une bride (86) sphérique fixée à la partie de maintien de la pastille de côté supérieur ;
un siège (84) sphérique fixé à la barre (80) d'élévation et
une bride (85) de fixation fixée au siège (84) sphérique, et configurée pour relier la bride (86) sphérique au siège (84) sphérique en y supportant la bride (85) sphérique.
